(19) Europäisches Patentamt

European Patent Office

Office européen des brevets

(11) **EP 1 324 498 B1**

(12) **EUROPEAN PATENT SPECIFICATION**

(45) Date of publication and mention
of the grant of the patent:
**03.08.2005 Bulletin 2005/31**

(51) Int Cl.[7]: **H03M 3/00**

(21) Application number: **02012046.5**

(22) Date of filing: **31.05.2002**

(54) **A method for self-calibrating a phase integration error in a modulator**

Verfahren zur Selbstkalibrierung eines Phasen-Integrationsfehlers in einem Modulator

Procédé pour l'étalonnage automatique d'une erreur d'intégration de phase dans un modulateur

(84) Designated Contracting States:
**DE FR GB IT**

(30) Priority: **27.12.2001 EP 01830815**

(43) Date of publication of application:
**02.07.2003 Bulletin 2003/27**

(73) Proprietor: **STMicroelectronics S.r.l.**
**20041 Agrate Brianza (Milano) (IT)**

(72) Inventors:
• **Gandolfi, Gabriele**
**27010 Siziano, (Pavia) (IT)**
• **Baschirotto, Andrea**
**15057 Tortona, (Alessandria) (IT)**
• **Colonna, Vittorio**
**27015 Landriano, (Pavia) (IT)**

(74) Representative: **Botti, Mario**
**Botti & Ferrari S.r.l.,**
**Via Locatelli, 5**
**20124 Milano (IT)**

(56) References cited:
**US-B1- 6 172 631**

• **FATTARUSO J W ET AL: "SELF-CALIBRATION TECHNIQUES FOR A SECOND-ORDER MULTIBIT SIGMA-DELTAMODULATOR" IEEE INTERNATIONAL SOLID STATE CIRCUITS CONFERENCE, IEEE INC. NEW YORK, US, vol. 36, February 1993 (1993-02), pages 228-229,293, XP000388087 ISSN: 0193-6530**
• **UENO F ET AL: "An oversampled sigma-delta A/D converter using time division multiplexed integrator" CIRCUITS AND SYSTEMS, 1990., PROCEEDINGS OF THE 33RD MIDWEST SYMPOSIUM ON CALGARY, ALTA., CANADA 12-14 AUG. 1990, NEW YORK, NY, USA,IEEE, US, 12 August 1990 (1990-08-12), pages 748-751, XP010047946 ISBN: 0-7803-0081-5**

**Description**

<u>Field of Application</u>

The present invention relates to a method of self-calibrating a phase integration error in a modulator.

More precisely, the invention relates to a method of self-calibrating a modulator of the type having at least one integrator that is liable to incur a phase error.

The invention further relates to a modulator structure with phase error correction, which comprises essentially an oscillation loop connected between an input terminal and an output terminal, itself comprising at least first and second integrators and first and second integration coefficients provided between the input terminal and said oscillation loop, and a feedback coefficient provided between said second integrator and said input terminal.

The invention relates, particularly but not exclusively, to a band-pass modulator of the sigma-delta ($\Sigma\Delta$) type having high-performance, and the description herein below will make reference to this field of application for convenience of illustration.

<u>Prior Art</u>

As is well known, band-pass modulators of the sigma-delta ($\Sigma\Delta$) type having high-performance are used in many communication systems, as instance in audio signal, MPX, and medium frequency (10.7 MHz) modulators.

A band-pass modulator of the sigma-delta ($\Sigma\Delta$) type comprising a sampling circuit for double sampling an input signal is known from the US patent No. 6,172,631 issued on January 9, 2001 in the name of Tsai et al.

In particular, the following are basic requirements of such modulators:

- high dynamic range;

- compact size; and

- low power dissipation.

A band-pass structure of the sigma-delta ($\Sigma\Delta$) low-order (usually second-order) multi-bit type is normally used in order to obtain a modulator having the above features.

A main problem with band-pass modulators of the sigma-delta ($\Sigma\Delta$) type is centring the so-called noise notch (noise mid-frequency) with a required accuracy of within 0.2% with respect to a nominal value (e.g. 10.7 MHz). In fact, it is only in this way that the dynamic range of the output signal from the modulator will suffer no drastic reduction.

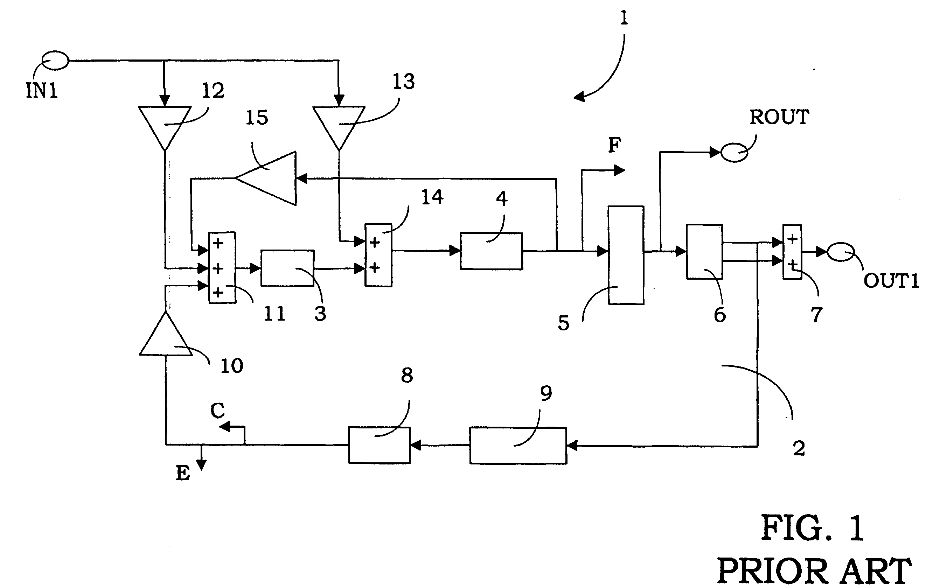

A known sigma-delta ($\Sigma\Delta$) modulator structure is generally shown at 1 in Figure 1.

The modulator 1 essentially comprises an oscillation loop 2, connected between an input terminal IN 1 and an output terminal OUT1.

The oscillation loop 2 comprises at least first and second integrators 3 and 4, a quantizer 5, and a stabilizer 6, which are connected in series together between the input terminal IN1 and the output terminal OUT1. In particular, the stabilizer 6 has a first output terminal feedback-connected, through a randomizer 8, a delay element 9, and a first integration coefficient 10, to a first summing element 11, itself connected between the input terminal IN1 and the first integrator 3. The stabilizer 6 is also connected to the output terminal OUT1 through a second summing element 7, to which a second output terminal of the stabilizer is also connected.

The modulator 1 also comprises a second integration coefficient 12, connected between the input terminal IN 1 and the first summing element 11, and a third integration coefficient 13, connected between the input terminal IN1 and the second integrator 4 through a third summing element 14.

The modulator 1 finally comprises a feedback coefficient 15, which is connected between an output terminal of the second integrator 4 and the first summing element 11, and an output verify terminal ROUT1 at an output terminal of the quantizer 5.

In particular, the integration coefficients 10, 12 and 13, and the feedback coefficient 15, are provided in a simple manner by appropriate capacitance ratios.

It should be noted that, in a conventional modulator as shown in Figure 1, the following are the main factors that cause the mid-frequency to shift:

- the capacitive matching of the elements in the modulator 1, which changes the coefficients, especially the gain g thereof; and

- the non-ideal nature of the integrators 3 and 4, which have finite gain and band*gain product and introduce re-

spective phase errors $b_1$, $b_2$ and gain errors $a_1$, $a_2$ in accordance with the following general relation:

$$\frac{y_n(z)}{x_n(z)} = \frac{a_n^* z^{-1}}{1 - b_n^* z^{-1}} \tag{1}$$

The drop in performance of the modulator 1, therefore, is essentially tied to the base block that contains the oscillation loop 2, itself comprising the two integrators 3, 4 and fixing the gain coefficient g.

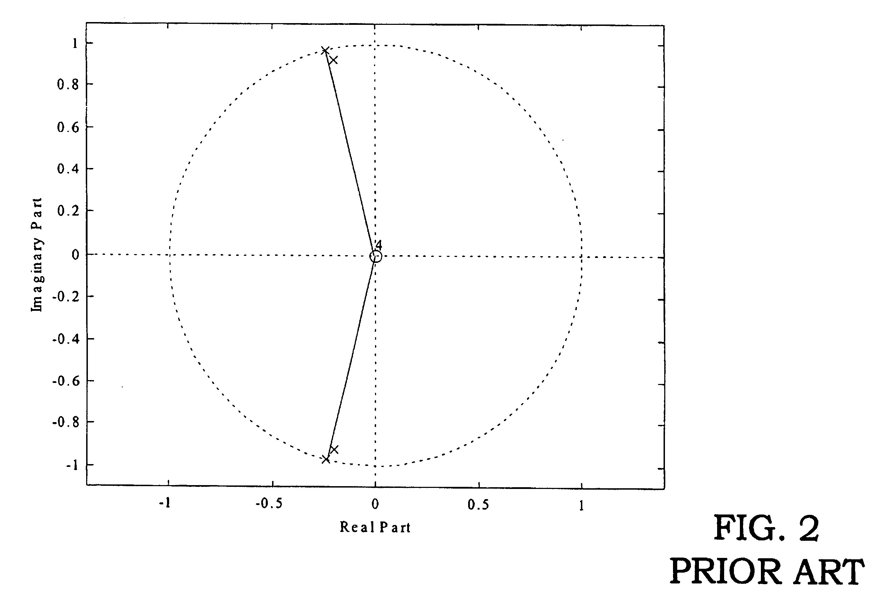

In particular, the oscillation loop 2 generates two complex conjugate-modulo poles, which ideally lie at an angle of 10.7 MHz from each other as shown schematically in Figure 2. The coefficient g and gain error $a_n$ of the integrators alter the pole angle, while the phase error $b_n$ of the integrators alters the pole modulo.

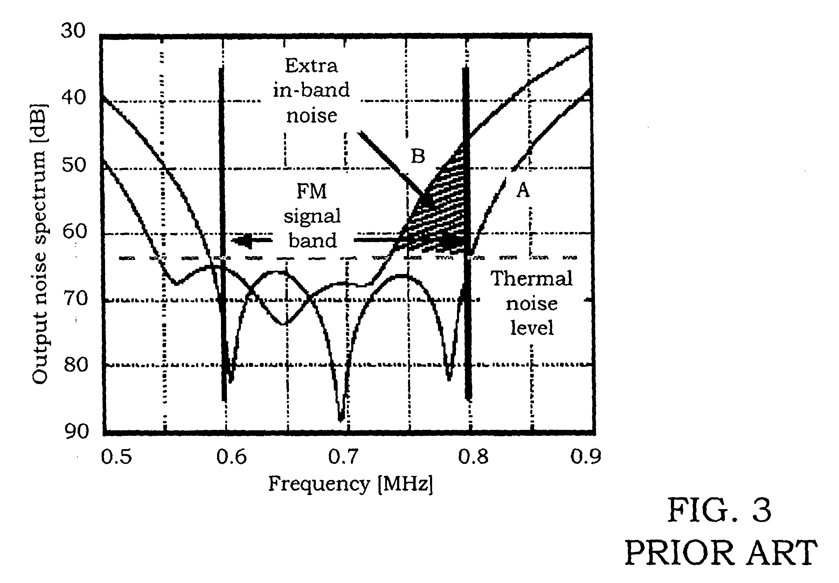

Thus, the output noise spectrum from the modulator 1 is as shown schematically in Figure 3, where the shaded area is the undesired offband noise.

Known are several self-calibration methods, wherein the response to pulse of an open-loop filter is utilised to measure the mid-frequency of the modulated signal.

To have this parameter satisfactorily calibrated, however, a sequence of sample responses to pulse are to be monitored for an extended length of time. It therefore becomes necessary to control the phase integration error because the response to pulse tapers out in relation to this parameter.

For the purpose, prior methods make use especially of the following techniques:

- using a master/slave system in which a master circuit is controlled to calibrate the modulator 1, with the modulator forming the slave circuit; this technique involves duplicating the modulator hardware, and is beset with problems of matching the master and slave structures;

- compensating the effect of the finite gain introduced by the integrators; and

- increasing the area of the capacitors inside the modulator 1 to achieve a match within less than 0.2%.

The underlying technical problem of this invention is to provide a method of self-calibrating a sigma-delta ($\Sigma\Delta$) modulator, which can compensate for the phase error due to the modulator, and in this way, overcome the limitations and obviate the drawbacks of the methods used in prior art modulators.

Summary of the Invention

The solvent idea of this invention is to provide at least one step of reading the response to pulse of the modulator, a step of computing a phase error parameter, and a step of calibrating the phase error parameter by counting those sample responses which lie above a suitably selected threshold.

In particular, an integrator system with phase error correction is provided which comprises a variable capacitor.

This eliminates the problems connected with a duplication of hardware, undesired leftover effects, and the need of increased capacitance, which beset the calibration techniques used in prior modulators.

Based on this idea, the technical problem is solved by a self-calibration method as defined in Claim 1.

The problem is also solved by a modulator structure as defined in Claim 10.

The features and advantages of the self-calibration method and the modulator structure according to the invention will be apparent from the following description of embodiments thereof, given by way of example and not of limitation with reference to the accompanying drawings.

Brief Description of the Drawings

In the drawings:

Figure 1 shows schematically a band-pass structure of a prior art modulator;

Figure 2 shows the pattern of the poles of frequency response in the modulator of Figure 1;

Figure 3 is a graph of the noise spectrum of the output signal from the modulator of Figure 1, plotted against frequency;

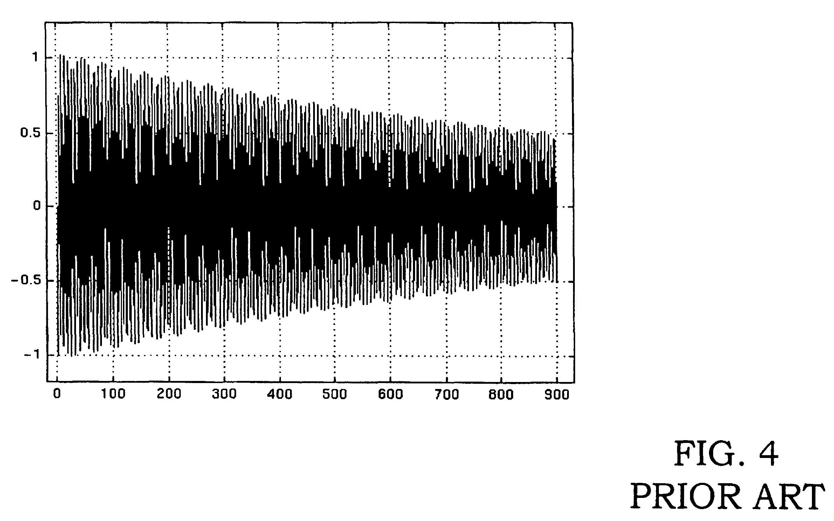

Figure 4 shows schematically the response-to-pulse pattern of the modulator of Figure 1;

Figure 5 shows schematically the response-to-pulse pattern of a modulator structure according to the invention;

Figure 6 shows schematically an integrator system with phase error correction according to the invention; and

Figure 7 shows schematically a modulator structure adapted to implement the self-calibration method according to the invention.

Detailed Description

The self-calibration method according to the invention will be described in relation to a second-order multi-bit band-pass modulator of the sigma-delta ($\Sigma\Delta$) type, by way of example and not of limitation. In particular, the described method and the results so obtained apply equally to any types of switched integrator.

Advantageously according to the invention, the self-calibration method provides for analysing the amplitude of the response to pulse of the modulator in order to correct the phase error incurred by the integrators contained in the modulator.

Making reference to a conventional modulator structure, such as modulator 1 shown in Figure 1, due to its non-ideal nature and the capacitive matching problem, the transfer functions of the first and second integrators 3 and 4 are given as:

$$\frac{y_1(z)}{x_1(z)} = \frac{a_1 {}^* z^{-1}}{1 - b_1 {}^* z^{-1}} \tag{2}$$

$$\frac{y_2(z)}{x_2(z)} = \frac{a_2 {}^* z^{-1}}{1 - b_2 {}^* z^{-1}} \tag{3}$$

where: $a_1$, $a_2$ are the gain error parameters and $b_1$, $b_2$ the phase error parameters of the integrators.

It should be noted that the parameters $a_1$, $a_2$ and $b_1$, $b_2$ would equal one under ideal conditions, and be less than one under real conditions.

The method according to the invention advantageously comprises a step of measuring the phase error parameters ($b_1$, $b_2$) of the integrators and a step of calibrating them by the response to pulse of the modulator that is containing them.

As later described in detail, the response to pulse of a modulator shows the following form:

$$V_0(n^*T) = K^{n^*T} {}^* \sin(n^* \omega_0 {}^* T) \tag{4}$$

where, K is the so-called dumping factor and equals $b_1{}^*b_2$.

As the parameters $b_1$ and $b_2$ approach unity, the dumping factor K also approaches unity, and the response to pulse remains other than zero through several cycles. Otherwise, the response becomes zero after a few samples, and will grant no accurate analysis of the response to pulse of the modulator structure.

Advantageously according to the invention, the self-calibration method comprises a step of measuring the phase error parameters $b_1$ and $b_2$, and a calibrating step to bring them as close as possible to one (the ideal value). The correct parameters $b_1$ and $b_2$ will be advantageously less than one, to avoid all problems of stability of the modulator structure.

In particular, the self-calibration method according to the invention comprises essentially the following steps:

- reading the modulator response to pulse;

- calculating the values of the phase error parameters $b_1$ and $b_2$; and

- calibrating the parameters $b_1$ and $b_2$ to make them equal to target values.

For simplicity, only the phase error parameter $b_1$ will be considered herein, since the same reasoning would apply to the phase error parameter $b_2$ as well.

In particular, the reading step uses the response to a pulse signal $\delta$ of the integrator having the following form:

$$y(n*T) = b_1{}^{n}*K*a_1 \tag{5}$$

Using the well-known mathematical tool represented by the Z-transform, it can be easily shown that the transfer function of the integrator shows the form:

$$\frac{y(z)}{x(z)} = \frac{a_1{}^*z^{-1}}{1 - b_1{}^*z^{-1}} \tag{6}$$

and, since according to the Z-transform:

$$Z(k * \partial(n * T)) = k \tag{7}$$

it is found that the Z-transform of the modulator output is given by:

$$y(z) = \frac{k^*a_1{}^*z^{-1}}{1 - b_1{}^*z^{-1}} \tag{8}$$

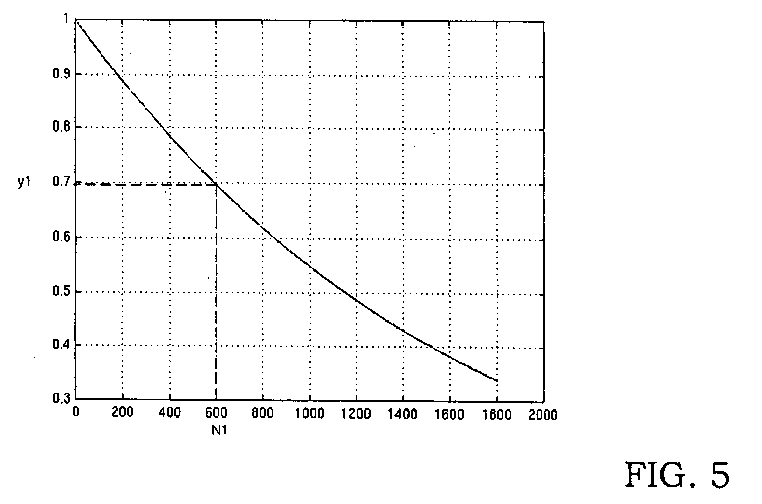

By reverse-transforming Equation (8), based on the known Z-transform table, Equation (5) above is arrived at. Figure 5 shows schematically the pattern of the output y(nT) when the product $k*a_1$ is one and $b_1$=0.9994.

Advantageously according to the invention, the phase error self-calibration method comprises a step of calculating the phase error parameter $b_1$ by measuring a number N1 of samples for which the response-to-pulse given by Equation (5) is above a threshold value y1. Thus, the phase error parameter $b_1$ of the integrator can be calculated from the following equation.

$$(b_1)^{N1} = \frac{y1}{k^*a_1} \tag{9}$$

i.e., once the logarithmic function is applied:

$$Log_{10}(b_1) = \frac{Log_{10}\left(\dfrac{y1}{k*a_1}\right)}{N1} \tag{10}$$

Equation (10) thus found is non-linear and can be solved in a tabular fashion, i.e. within the digital domain, it allowing the value of the phase error parameter $b_1$ to be calculated.

For example, when a flash type of analog-to-digital converter is used, different threshold values y1 can be found for improving the read accuracy of the inventive method, as by dividing the range of the parameter $b_1$ to be calibrated into zones, each zone having a different threshold value.

In particular, as the parameter $b_1$ has far from unity values, low values of the threshold y1 should be used, while as the parameter $b_1$ has near unity values, threshold values of the threshold y1 approaching one are more suitable.

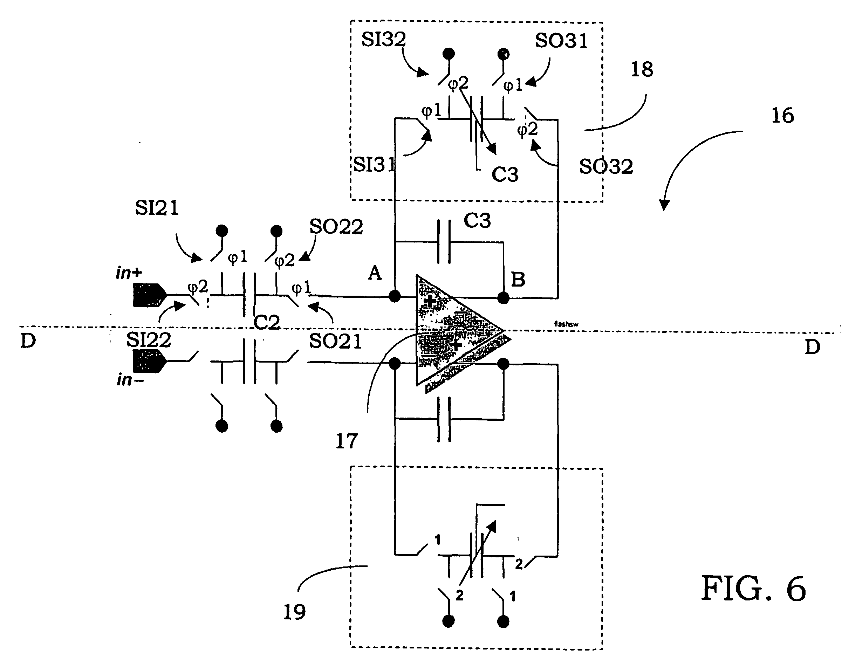

The parameter $b_1$ thus found is corrected during the calibration step. In particular, advantageously according to the invention, the integrator system 16 with phase error correction shown schematically in Figure 6 is used.

In particular, the integrator system 16 comprises an integrator 17, having a non-inverting input terminal A connected to an inverting output terminal B through a first feedback capacitor C1.

The integrator system 16 also comprises a second input capacitor C2, connected between a first input terminal IN+ and the non-inverting input terminal A of the integrator 17 through complementary pairs SI21, SI22 and SO21, SO22 of switches that are driven by first and second phase signals φ1 and φ2.

Advantageously according to the invention, the integrator system 16 further comprises a phase error correction portion 18 that is feedback connected between the output terminal B and the input terminal A of the integrator 17.

In particular, the correction portion 18 comprises essentially a third capacitor C3, which is connected between the output terminal B and the input terminal A of the integrator 17, again through complementary switch pairs SI31, SI32 and SO31 SO32 driven by the first and second phase signals φ1 and φ2.

In the integrator system 16, the correction portion 18 is mirrored about a line DD by another correction portion 19, into a classical full-ended configuration no further described herein.

It should be noted that, advantageously according to the invention, the third capacitor C3 has variable capacitance Cv to produce a positive feedback around the integrator 17 so as to add an amount of charge lost to the non-ideal nature of the integrator, thereby increasing the value of parameter $b_1$.

In particular, the variable capacitance Cv of the third capacitor C3 places a multiplying term before the term $z^{-1}$ in the transfer function of the integrator system, thus correcting the parameter $b_1$ as per the following relation:

$$H(z) = \frac{a_1 * z^{-1}}{1 - b_1 * \left(1 + \dfrac{C_v}{C_2}\right) * z^{-1}} \tag{11}$$

As the variable capacitance Cv is increased, the coefficient of $z^{-1}$ in the denominator increases to near unity value.

In essence, the integrator system 16 allows the phase error of the modulator comprising the integrator 17 to be corrected by merely adjusting the variable capacitance value Cv.

When the above-described self-calibration method is used, the integrator system 16 is controlled by a digital algorithm providing a count of those samples whose value exceeds a suitably preset threshold value, thereby to close in upon this threshold value.

In particular, the self-calibration method according to the invention comprises the following steps:

- counting the samples that are above a set of threshold values;

- choosing an optimum value for the threshold value within the set of threshold values;

- solving Equation (10) for obtaining the phase error parameter $b_1$ evaluation;

  changing the variable capacitance value Cv according to the above obtained parameter $b_1$ evaluation.

Advantageously in this invention, the reading and calculating steps, and the step of calibrating the phase error by changing the capacitance Cv of the third capacitor C3, are iterated to bring the value of the parameter $b_1$ to within a desired range, which may be the following:

$$1 - 800e^{-6} \leq b_1 \leq 1 - 400e^{-6} \tag{12}$$

Advantageously according to the invention, the described self-calibration method allows most of the hardware to be shifted to the digital domain and the analog elements to be reduced to a minimum which are to be connected in the modulator structure for correction purposes.

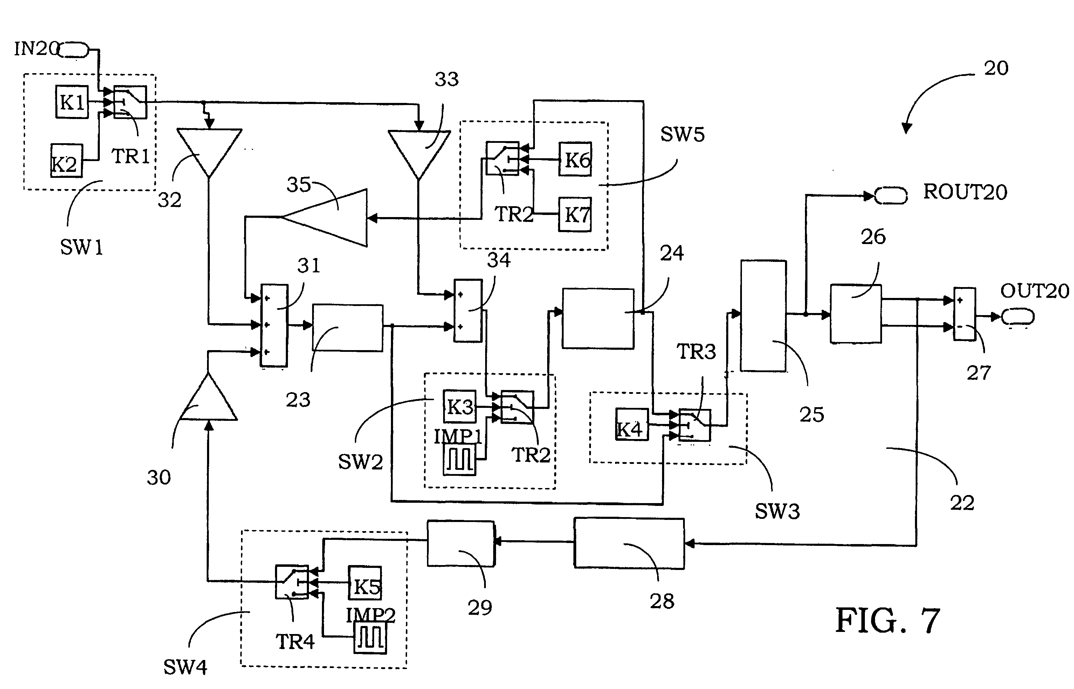

A band-pass modulator structure of the sigma-delta (ΣΔ) type adapted to implement a phase error correction according to the described self-calibration method is shown generally at 20 in Figure 7.

As shown in connection to the prior art, the modulator 20 essentially comprises an oscillation loop 22 connected between an input terminal IN20 and an output terminal OUT20.

The oscillation loop 22 in turn comprises at least first and second integrators 23 and 24, a quantizer 25, and a stabilizer 26, being all connected in series together between the input terminal IN20 and the output terminal OUT20. In particular, the stabilizer 26 has a first output terminal feedback connected, through a randomizer 28. a delay element 29, and a first integration coefficient 30, to a first summing element 31, which is connected between the input terminal IN20 and the first integrator 23 and connected to the output terminal OUT20 through a second summing element 27 having a second output terminal of the stabilizer 26 connected thereto.

The modulator 20 comprises also a second integration coefficient 32, connected between the input terminal IN20 and the first summing element 31, and comprises a third integration coefficient 33, connected between the input terminal IN20 and the second integrator 24 through a third summing element 34.

The modulator 20 further comprises a feedback coefficient 35 provided between an output terminal of the second integrator 24 and the first summing element 31, and comprises an output verify terminal ROUT20 at the output terminal of the quantizer 25.

The integration coefficients 30, 32 and 33, and the feedback coefficient 35 are in the form of appropriate capacitive ratios.

To implement the self-calibration method according to the invention, the following are additionally provided:

- a first switch block SW1, connected between the input terminal IN20 and the second and third integration coefficients 32 and 33;

- a second switch block SW2, connected between the third summing element 34 and the second integrator 24;

- a third switch block SW3, connected between the second integrator 24 and the quantizer 25;

- a fourth switch block SW4, connected between the delay element 29 and the first integration coefficient 30; and

- a fifth switch block SW5, connected between the output of the second integrator 24 and the feedback coefficient 35.

More particularly, the first switch block SW1 comprises a three-way switch TR1, which is input the signal at the input terminal IN20 and first and second constant signals K1 and K2, and has its output connected to the second and third integration coefficients 32 and 33.

The second switch block SW2 similarly comprises a three-way switch TR2, which is input a third constant signal K3, a first pulse signal IMP1, and the output signal from the third summing element 34, and has its output connected to the second integrator 24.

Also, the third switch block SW3 comprises a three-way switch TR3, which is input a fourth constant signal K4 and the output signals from the first and second integrators 23 and 24, and has its output connected to the quantizer 25.

The fourth switch block SW4 comprises a three-way switch TR4, which is input a fifth constant signal K5, a second pulse signal IMP2, and the output signal from the delay element 29, and has its output connected to the first integration coefficient 30.

Finally, the fifth switch block SW5 comprises a three-way switch TR5, which is input sixth and seventh constant signals K6 and K7, and the output signal from the second integrator 24, and has its output connected to the feedback coefficient 35.

The modulator 20 shown in Figure 7 is adapted to implement the self-calibration method according to the invention.

In particular, the fourth switch block SW4 "breaks" the oscillation loop 22 after the delay element 29, and allows the notch frequency of the modulator noise to be measured.

In this way, the noise contribution from the input terminal IN20 is suppressed, and a pulse signal IMP2 can be input to the first integration coefficient 30.

The response to pulse of the modulator 20 is then measured at the input of the quantizer 25 using the third switch block SW3.

To summarise, the self-calibration method according to the invention, as implemented by the modulator 20 of Figure 7, comprises the steps listed here below.

1) Reading the value of the parameter $b_1$ of the first integrator 23 by resetting the switch blocks SW1, SW4, SW5 and SW3 in this order, thereby:

- suppressing the contribution from the input terminal IN20;

- applying a pulse signal IMP1 to the first integrator 23 and opening the circuit of the modulator 20;

- breaking the oscillation loop 22; and

- connecting the output of the first integrator 23 to a flash analog-to-digital converter.

2) Computing the difference of the read value of the actual parameter $b_1$ from its target value.

3) Correcting the value of parameter $b_1$ by programming the variable capacitor Cv of an integrator system 16 with phase error correction, as shown in Figure 6, which comprises the first integrator 23, using the results of Step 2 above.

4) Repeating Steps 1 to 3 until the measured value of parameter $b_1$ equals the target value plus/minus a preset allowed error.

It should be noted that, advantageously according to the invention, the value of parameter $b_1$ is measured by counting the samples of the modulator response to pulse which lie above appropriate threshold values, and which the value Cv of an associated capacitor with the integrators keeps changing until the phase error parameter $b_1$ fulfils relation (12) above.

The sequence of steps listed hereinabove are then applied to the second integrator 24, starting with the switch block SW2 being reset instead of switch block SW1.

Although the ideal values of the phase error parameters $b_1$ and $b_2$ is one, to achieve the target performance and a stable system, any parameters that fulfil relation (12) above may be acceptable.

**Claims**

1. A method of self-calibrating a modulator having at least one integrator (23, 24) that is liable to incur a phase error, the method being **characterised in that** it comprises at least one step of reading a response to pulse of said modulator, a step of calculating a phase error parameter ($b_1$, $b_2$) of said integrator, and a step of calibrating said phase error parameter ($b_1$, $b_2$), and **in that** said calibrating step provides a sample count (N1) of the response-to-pulse samples lying above a set of threshold values (y1), and a change in the value (Cv) of a capacitor associated with said integrator according to said sample count (N1).

2. A self-calibration method according to Claim 1, **characterised in that** said steps of calculating and calibrating said phase error parameter ($b_1$, $b_2$) are reiterated until the value of said phase error parameter ($b_1$, $b_2$) lies within a desired range.

3. A self-calibration method according to Claim 2, **characterised in that** said steps of measuring and correcting said phase error parameter ($b_1$, $b_2$) are reiterated until the value of said phase error parameter ($b_1$, $b_2$) lies within the following range:

$$1\text{-}800e^{-6} \leq b_1 \leq 1\text{-}400e^{-6}$$

4. A self-calibration method according to Claim 2, **characterised in that** said step of calibrating said phase error parameter ($b_1$, $b_2$) is carried out in an integrator system that comprises said integrator and a variable capacitor (C3) associated with said integrator, the capacitance value (Cv) of said capacitor being changed according to said sample count.

5. A self-calibration method according to Claim 1, **characterised in that** said step of calibrating said phase error parameter ($b_1$, $b_2$) provides for bringing said parameter close to one, this being regarded as a target value.

6. A self-calibration method according to Claim 1, **characterised in that** said step of calculating said phase error parameter ($b_1$, $b_2$) of said integrator provides for solving the following equation:

$$(b_1)^{N1} = \frac{y1}{k^*a_1}$$

by application of the following logarithmic function:

$$Log_{10}(b_1) = \frac{Log_{10}\left(\frac{y1}{k*a_1}\right)}{N1}$$

and solving said logarithmic equation in a tabular form within the digital domain.

7. A self-calibration method according to Claim 6, **characterised in that** said solution to said logarithmic equation is realised by using a Flash analog-to-digital converter and attempting different threshold values (y1) in order to improve the accuracy of said step of measuring said phase error parameter ($b_1$, $b_2$) of said integrator.

8. A self-calibration method according to Claim 4, **characterised in that** said capacitor (C3) is associated with said integrator to produce a positive feedback around said integrator so as to add an amount of charge lost to the non-ideal nature of said integrator, thereby raising the value of said phase error parameter ($b_1$) of said integrator according to the relation:

$$H(z) = \frac{a_1 * z^{-1}}{1 - b_1 * \left(1 + \frac{C_v}{Cn}\right) * z^{-1}}$$

where,

H(z) is the transfer function of said integrator system;

$a_1$ is a gain error parameter of said integrator; and

Cn is the capacitance of a feedback capacitor connected to said integrator.

9. A self-calibration method according to Claim 8, **characterised in that** said calculation and calibration steps include the following steps:

- counting the samples that are above a set of threshold values;

- choosing an optimum value for the threshold value within said set of threshold values;

- solving the following equation:

$$Log_{10}(b_1) = \frac{Log_{10}\left(\frac{y1}{k * a_1}\right)}{N1}$$

for obtaining a phase error parameter ($b_1$) evaluation;

- changing said variable capacitance value (Cv) according to said parameter ($b_1$) evaluation obtained by the above step.

10. A modulator structure (20) with phase error correction, essentially comprising an oscillation loop (22) connected between an input terminal (IN20) and an output terminal (OUT20), itself including at least first and second integrators (23, 24) and first and second integration coefficients (32, 33) connected between the input terminal (IN20) and said oscillation loop (22), and a feedback coefficient (35) connected between said second integrator (24) and said input terminal (IN20); **characterised in that** it comprises:

- a first switch block (SW1) connected between said input terminal (IN20) and said first and second integration coeffcients (32, 33);

- a second switch block (SW2) connected between said first and second integrators (23, 24);

- a third switch block (SW3) connected between said second integrator (24) and said output terminal (OUT20);

- a fourth switch block (SW4) connected within said feedback loop (22); and

- a fifth switch block (SW5) connected between said second integrator (24) and said feedback coefficient (35)

and **in that** it further comprises a phase error correction portion (18) feedback connected between an output terminal and an input terminal of said second integrator (24), said correction portion (18) having a variable capacitance value (Cv) which is changed in accordance with a sample count (N1) of response-to-pulse samples lying above a set of threshold values (y1).

11. A modulator structure (20) with phase error correction according to Claim 10, **characterised in that** said fourth switch block (SW4) allows said oscillation loop (22) to be broken in order to apply a pulse signal (IMP2), and said third switch block (SW3) allows the response to pulse of said modulator structure (20) to be measured.

12. A modulator structure (20) with phase error correction according to Claim 10, **characterised in that** said first, fourth, fifth and third switch blocks (SW1, SW4, SW5, SW3) are reset sequentially to enable the following sequential operations:

1) reading the value of a phase error parameter ($b_1$) of said first integrator (23) to cancel the contribution from said input terminal (IN20) by applying a pulse signal (IMP1) to said first integrator (24), breaking said oscillation loop (22), and connecting the output of said first integrator (23) to a Flash analog-to-digital converter;

2) computing the difference of said read value of said phase error parameter ($b_1$) from a target value thereof;

3) calibrating said read value of said phase error parameter ($b_1$) by programming said variable capacitance value (Cv) of said phase error correction portion (18), wherein said first integrator (23) is provided, using the results of the computing step 2 above; and

4) repeating reading step 1, computing step 2 and calibrating step 3 until said read value of said phase error parameter ($b_1$) equals said target value.

13. A modulator structure (20) with phase error correction according to Claim 12, **characterised in that** said sequential operations are also applied to said second integrator (24) by initially resetting said second switch block (SW2).

14. A modulator structure (20) with phase error correction according to Claim 10, **characterised in that** said second switch block (SW2) comprises at least one switch (TR2) being input at least one pulse signal (IMP1).

15. A modulator structure (20) with phase error correction according to Claim 10, **characterised in that** said third switch block (SW3) comprises at least one switch (TR3) being input output signals from said first and second integrators (23, 24).

16. A modulator structure (20) with phase error correction according to Claim 10, **characterised in that** said fourth switch block (SW4) comprises at least one switch (TR4) being input at least one pulse signal (IMP2).

17. A modulator structure (20) with phase error correction according to Claim 10, **characterised in that** said fifth switch block (SW5) comprises at least one switch (TR5) being input an output signal from said second integrator (24).

18. A modulator structure (20) with phase error correction according to Claim 10, **characterised in that** said correction portion (18) comprises essentially a third capacitor (C3) connected between said output terminal and said input terminal of said second integrator (24), said third capacitor (C3) having said variable capacitance value (Cv) and being adapted to produce a positive feedback around said second integrator (24).

19. A modulator structure (20) with phase error correction according to Claim 18, **characterised in that** said third capacitor (C3) is connected between said output terminal and said input terminal of said second integrator (17) through complementary switch pairs (SI31, SI32; SO31, SO32) driven by first and second phase signals ($\varphi1$, $\varphi2$).

20. A modulator structure (20) with phase error correction according to Claim 10, **characterised in that** it comprises an additional correction portion (19) connected to said second integrator (24) symmetrically with respect to said correction portion (18).

**Patentansprüche**

1. Verfahren zur Selbstkalibrierung eines Modulators mit mindestens einem Integrator (23, 24), der dazu neigt, einen Phasenfehler einzubringen, wobei das Verfahren **dadurch gekennzeichnet ist, dass** es mindestens einen Schritt des Lesens einer Impulsantwort des Modulators, einen Schritt der Berechnung eines Phasenfehlerparameters ($b_1$, $b_2$) des Integrators und einen Schritt der Kalibrierung des Phasenfehlerparameters ($b_1$, $b_2$) umfasst, und dass der Kalibrierungsschritt einen Zählwert (N1) der Abtastwerte der Impulsantwort-Abtastwerte bereitstellt, welcher oberhalb einer Menge von Schwellenwerten (y1) liegt, und gemäß dem Zählwert (N1) der Abtastwerte eine Veränderung des Werts (Cv) eines Kondensators, welcher dem Integrator zugeordnet ist.

2. Selbstkalibrierungsverfahren nach Anspruch 1, **dadurch gekennzeichnet, dass** die Schritte der Berechnung und Kalibrierung des Phasenfehlerparameters ($b_1$, $b_2$) wiederholt werden, bis der Wert des Phasenfehlerparameters ($b_1$, $b_2$) innerhalb einer gewünschten Bandbreite liegt.

3. Selbstkalibrierungsverfahren nach Anspruch 2, **dadurch gekennzeichnet, dass** die Schritte der Messung und Korrektur des Phasenfehlerparameters ($b_1$, $b_2$) wiederholt werden, bis der Wert des Phasenfehlerparameters ($b_1$, $b_2$) innerhalb der folgenden Bandbreite liegt:

$$1 - 800e^{-6} \leq b1 \leq 1 - 400e^{-6}$$

4. Selbstkalibrierungsverfahren nach Anspruch 2, **dadurch gekennzeichnet, dass** der Schritt der Kalibrierung des Phasenfehlerparameters ($b_1$, $b_2$) in einem Integratorsystem ausgeführt wird, welches den Integrator und einen dem Integrator zugeordneten, veränderbaren Kondensator (C3) umfasst, wobei der Kapazitätswert (Cv) des Kondensators gemäß dem Zählwert der Abtastwerte verändert wird.

5. Selbstkalibrierungsverfahren nach Anspruch 1, **dadurch gekennzeichnet, dass** der Schritt der Kalibrierung des Phasenfehlerparameters ($b_1$, $b_2$) vorsieht, den Parameter nahe auf 1 zu bringen, wobei 1 als Sollwert angesehen wird.

6. Selbstkalibrierungsverfahren nach Anspruch 1, **dadurch gekennzeichnet, dass** der Schritt der Berechnung des Phasenfehlerparameters ($b_1$, $b_2$) des Integrators die Lösung der folgenden Gleichung vorsieht:

$$(b_1)^{N1} = \frac{y1}{k^* a_1}$$

unter Anwendung der folgenden logarithmischen Funktion:

$$Log_{10}(b_1) = \frac{Log_{10}\left(\dfrac{y1}{k*a_1}\right)}{N_1}$$

und Lösung der logarithmischen Gleichung in tabellarischer Form innerhalb des digitalen Bereichs.

7. Selbstkalibrierungsverfahren nach Anspruch 6, **dadurch gekennzeichnet, dass** die Lösung für die logarithmische Gleichung unter Verwendung eines Flash-Analog/Digital-Wandlers herbeigeführt wird und verschiedene Schwellenwerte (y1) ausprobiert werden, um die Genauigkeit des Schritts der Messung des Phasenfehlerparameters ($b_1$, $b_2$) des Integrators zu verbessern.

8. Selbstkalibrierungsverfahren nach Anspruch 4, **dadurch gekennzeichnet, dass** der Kondensator (C3) dem Integrator zugeordnet ist, um eine positive Rückkopplung am Integrator hervorzubringen, damit eine Menge an Ladung hinzugefügt wird, welche durch die nicht ideale Beschaffenheit des Integrators verloren geht, wodurch der Wert des Phasenfehlerparameters ($b_1$) des Integrators gemäß der Beziehung:

$$H(z) = \frac{a_1 * z^{-1}}{1 - b_1^* \left(1 + \frac{C_v}{C_n}\right) * z^{-1}}$$

ansteigt, wobei

$H(z)$ die Übertragungsfunktion des Integratorsystems ist;
$a_1$ ein Verstärkungsfehlerparameter des Integrators ist; und
Cn die Kapazität eines mit dem Integrator verbundenen Rückkopplungs-Kondensators ist.

9. Selbstkalibrierungsverfahren nach Anspruch 8, **dadurch gekennzeichnet, dass** in den Schritten der Berechnung und Kalibrierung folgende Schritte eingeschlossen sind:

- Zählen der Abtastwerte, welche über einer Menge von Schwellenwerten liegen;
- Auswählen eines optimalen Werts für den Schweltenwert innerhalb der Menge an Schwellenwerten;
- Lösung der folgenden Gleichung:

$$Log_{10}(b_1) = \frac{Log_{10}\left(\frac{y1}{k * a_1}\right)}{N_1}$$

um eine Bestimmung des Phasenfehlerparameters ($b_1$) zu erhalten;
- Verändern des veränderbaren Kapazitätswerts (Cv) gemäß der nach obigem Schritt erhaltenen Bestimmung des Parameters ($b_1$).

10. Modulatorstruktur (20) mit Phasenfehlerkorrektur, im Wesentlichen einen Schwingkreis (22) umfassend, der zwischen einem Eingangsanschluss (IN20) und einem Ausgangsanschluss (OUT20) angeschlossen ist, seinerseits mindestens einen ersten und einen zweiten Integrator (23, 24) sowie einen ersten und einen zweiten Integrationskoeffizienten (32, 33) umfassend, welche zwischen dem Eingangsanschluss (IN20) und dem Schwingkreis (22) angeschlossen sind, und einen Rückkopplungs-Koeffizienten (35), welcher zwischen dem zweiten Integrator (24) und dem Eingangsanschluss (IN20) angeschlossen ist; **dadurch gekennzeichnet, dass** sie umfasst:

- einen ersten Schaltblock (SW1), der zwischen dem Eingangsanschluss (IN20) und dem ersten und zweiten Integrationskoeffizienten (32, 33) angeschlossen ist;
- einen zweiten Schaltblock (SW2), der zwischen dem ersten und zweiten Integrator (23, 24) angeschlossen ist,
- einen dritten Schaltblock (SW3), der zwischen dem zweiten Integrator (24) und dem Ausgangsanschluss (OUT20) angeschlossen ist;
- einen vierten Schaltblock (SW4), der im Rückkopplungsschwingkreis (22) angeschlossen ist; und
- einen fünften Schaltblock (SW5), der zwischen dem zweiten Integrator (24) und dem Rückkopplungs-Koeffizienten (35) angeschlossen ist,

und dass sie darüber hinaus einen Phasenfehlerkorrekturabschnitt (18) umfasst, der rückkoppelnd zwischen einem Ausgangsanschluss und einem Eingangsanschluss des zweiten Integrators (24) angeschlossen ist, wobei der Korrekturabschnitt (18) einen veränderbaren Kapazitätswert (Cv) aufweist, welcher entsprechend einem Zählwert (N1) der Abtastwerte von oberhalb einer Menge von Schwellenwerten (y1) liegenden Impulsantwort-Abtastwerten verändert wird.

11. Modulatorstruktur (20) mit Phasenfehlerkorrektur nach Anspruch 10, **dadurch gekennzeichnet, dass** der vierte Schaltblock (SW4) die Unterbrechung des Schwingkreises (22) erlaubt, um ein Impulssignal (IMP2) anzulegen, und dass der dritte Schaltblock (SW3) das Messen der Impulsantwort (20) der Modulatorstruktur (20) erlaubt.

**12.** Modulatorstruktur (20) mit Phasenfehlerkorrektur nach Anspruch 10, **dadurch gekennzeichnet, dass** der erste, vierte, fünfte und dritte Schaltblock (SW1, SW4, SW5, SW3) sequentiell zurückgesetzt werden, um die folgenden sequentiellen Vorgänge zu ermöglichen:

1) Lesen des Werts eines Phasenfehlerparameters ($b_1$) des ersten Integrators (23), um durch Anlegen eines Impulssignals (IMP1) an den ersten Integrator (24) den Beitrag vom Eingangsanschluss (IN20) aufzuheben, den Schwingkreis (22) zu unterbrechen und den Ausgang des ersten Integrators (23) an einen Flash-Analog/Digital-Wandler anzuschließen;
2) Berechnung der Differenz zwischen dem Lesewert des Phasenfehlerparameters ($b_1$) und einem Sollwert davon;
3) Kalibrierung des Lesewerts des Phasenfehlerparameters ($b_1$) durch Programmierung des veränderbaren Kapazitätswerts (Cv) des Phasenfehlerkorrekturabschnitts (18), der mit dem Integrator (23) ausgestattet ist, unter Verwendung der Ergebnisse des oben genannten Berechnungsschritts 2); und
4) Wiederholung von Leseschritt 1), Berechnungsschritt 2) und Kalibrierungsschritt 3), bis der Lesewert des Phasenfehlerparameters ($b_1$) dem Sollwert entspricht.

**13.** Modulatorstruktur (20) mit Phasenfehlerkorrektur nach Anspruch 12, **dadurch gekennzeichnet, dass** die sequentiellen Operationen auch am zweiten Integrator (24) vorgenommen werden, indem der zweite Schaltblock (SW2) anfänglich zurückgesetzt wird.

**14.** Modulatorstruktur (20) mit Phasenfehlerkorrektur nach Anspruch 10, **dadurch gekennzeichnet, dass** der zweite Schaltblock (SW2) mindestens einen Schalter (TR2) umfasst, in den mindestens ein Impulssignal (IMP1) eingeht.

**15.** Modulatorstruktur (20) mit Phasenfehlerkorrektur nach Anspruch 10, **dadurch gekennzeichnet, dass** der dritte Schaltblock (SW3) mindestens einen Schalter (TR3) umfasst, in den Ausgangssignale des ersten und zweiten Integrators (23, 24) eingehen.

**16.** Modulatorstruktur (20) mit Phasenfehlerkorrektur nach Anspruch 10, **dadurch gekennzeichnet, dass** der vierte Schaltblock (SW4) mindestens einen Schalter (TR4) umfasst, in den mindestens ein Impulssignal (IMP2) eingeht.

**17.** Modulatorstruktur (20) mit Phasenfehlerkorrektur nach Anspruch 10, **dadurch gekennzeichnet, dass** der fünfte Schaltblock (SW5) mindestens einen Schalter (TR5) umfasst, in den ein Ausgangssignal des zweiten Integrators (24) eingeht.

**18.** Modulatorstruktur (20) mit Phasenfehlerkorrektur nach Anspruch 10, **dadurch gekennzeichnet, dass** der Korrekturabschnitt (18) im Wesentlichen einen dritten Kondensator (C3) umfasst, welcher zwischen dem Ausgangsanschluss und dem Eingangsanschluss des zweiten Integrators (24) angeschlossen ist, wobei der dritte Kondensator (C3) den veränderbaren Kapazitätswert (Cv) aufweist und dazu ausgelegt ist, eine positive Rückkopplung am zweiten Integrator (24) hervorzubringen.

**19.** Modulatorstruktur (20) mit Phasenfehlerkorrektur nach Anspruch 18, **dadurch gekennzeichnet, dass** der dritte Kondensator (C3) zwischen dem Ausgangsanschluss und dem Eingangsanschluss des zweiten Integrators (17) durch komplementäre Schalterpaare (SI31, SI32; SO31, S032) angeschlossen ist, welche durch erste und zweite Phasensignale ($\varphi1$, $\varphi2$) gesteuert werden.

**20.** Modulatorstruktur (20) mit Phasenfehlerkorrektur nach Anspruch 10, **dadurch gekennzeichnet, dass** sie einen zusätzlichen Korrekturabschnitt (19) umfasst, welcher im Hinblick auf den Korrekturabschnitt (18) symmetrisch an den zweiten Integrator (24) angeschlossen ist.


**Revendications**

**1.** Procédé d'étalonnage automatique d'un modulateur ayant au moins un intégrateur (23, 24) qui est susceptible de subir une erreur de phase, le procédé étant **caractérisé en ce qu'**il comprend au moins une étape de lecture d'une réponse à l'impulsion dudit modulateur, une étape de calcul d'un paramètre d'erreur de phase ($b_1$, $b_2$) dudit intégrateur, et une étape d'étalonnage dudit paramètre d'erreur de phase ($b_1$, $b_2$) et **en ce que** ladite étape d'étalonnage fournit un compte d'échantillons (N1), des échantillons de réponse à l'impulsion qui se trouvent au-dessus d'un ensemble de valeurs seuils (y1), et une modification de la valeur (Cv) d'un condensateur associé au dit intégrateur selon ledit compte d'échantillons (N1).

2. Procédé d'étalonnage automatique selon la revendication 1, **caractérisé en ce que** lesdites étapes de calcul et d'étalonnage dudit paramètre d'erreur de phase ($b_1$, $b_2$) sont réitérées jusqu'à ce que la valeur dudit paramètre d'erreur de phase ($b_1$, $b_2$) se trouve dans une plage souhaitée.

3. Procédé d'étalonnage automatique selon la revendication 2, **caractérisé en ce que** lesdites étapes de mesure et de correction dudit paramètre d'erreur de phase ($b_1$, $b_2$) sont réitérées jusqu'à ce que la valeur dudit paramètre d'erreur de phase ($b_1$, $b_2$) se trouve dans la plage suivante :

$$1 - 800e^{-6} \leq b_1 \leq 1 - 400e^{-6}.$$

4. Procédé d'étalonnage automatique selon la revendication 2, **caractérisé en ce que** ladite étape d'étalonnage dudit paramètre d'erreur de phase ($b_1$, $b_2$) est exécutée dans un système d'intégrateur qui comprend ledit intégrateur et un condensateur variable (C3) associé au dit intégrateur, la valeur de la capacité (Cv) dudit condensateur étant modifiée selon ledit compte d'échantillons.

5. Procédé d'étalonnage automatique selon la revendication 1, **caractérisé en ce que** ladite étape d'étalonnage dudit paramètre d'erreur de phase ($b_1$, $b_2$) suppose que le paramètre soit approché de un, ceci étant considéré comme une valeur cible.

6. Procédé d'étalonnage automatique selon la revendication 1, **caractérisé en ce que** ladite étape de calcul dudit paramètre d'erreur de phase ($b_1$, $b_2$) dudit intégrateur fournit la résolution de l'équation suivante :

$$(b_1)^{N1} = \frac{y1}{k^*a_1}$$

grâce à l'application de la fonction logarithmique suivante :

$$Log_{10}(b_1) = \frac{Log_{10}\left(\dfrac{y1}{k^*a_1}\right)}{N1}$$

et la résolution de ladite équation logarithmique sous une forme de tableau, à l'intérieur du domaine numérique.

7. Procédé d'étalonnage automatique selon la revendication 6, **caractérisé en ce que** ladite résolution de ladite équation logarithmique est réalisée en utilisant un convertisseur analogique - numérique Flash et en essayant différentes valeurs seuils (y1) afin d'améliorer la précision de ladite étape de mesure dudit paramètre d'erreur de phase ($b_1$, $b_2$) dudit intégrateur.

8. Procédé d'étalonnage automatique selon la revendication 4, **caractérisé en ce que** ledit condensateur (C3) est associé au dit intégrateur afin de produire une réaction positive autour dudit intégrateur, de façon à ajouter une quantité de charge perdue à la nature non idéale dudit intégrateur, ce qui relève ainsi la valeur dudit paramètre d'erreur de phase ($b_1$) dudit intégrateur selon la relation :

$$H(z) = \frac{a_1 * z^{-1}}{1 - b_1 * \left(1 = \dfrac{C_v}{Cn}\right) * z^{-1}}$$

dans laquelle,

H(z) est la fonction de transfert dudit système d'intégrateur ;
$a_1$ est un paramètre d'erreur de gain dudit intégrateur ; et
Cn est la capacité d'un condensateur de réaction connecté au dit intégrateur.

**9.** Procédé d'étalonnage automatique selon la revendication 8, **caractérisé en ce que** lesdites étapes de calcul et d'étalonnage incluent les étapes suivantes :

- compte des échantillons qui se trouvent au-dessus d'un jeu de valeurs seuils;
- sélection d'une valeur optimale pour la valeur seuil à l'intérieur dudit jeu de valeurs seuils ;
- résolution de l'équation suivante :

$$\text{Log}_{10}(b_1) = \frac{\text{Log}_{10}\left(\dfrac{y1}{k * a_1}\right)}{N1}$$

afin d'obtenir une évaluation du paramètre d'erreur de phase ($b_1$) ;
- modification de ladite valeur de capacité variable (Cv) selon ladite évaluation du paramètre ($b_1$) obtenue grâce à l'étape précédente.

**10.** Structure de modulateur (20) avec une correction d'erreur de phase, comprenant essentiellement une boucle d'oscillation (22) connectée entre une borne d'entrée (IN20) et une borne de sortie (OUT20), elle-même incluant au moins un premier et un deuxième intégrateurs (23, 24) et des premier et deuxième coefficients d'intégration (32, 33) connectés entre la borne d'entrée (IN20) et ladite boucle d'oscillation (22), et un coefficient de réaction (35) connecté entre ledit deuxième intégrateur (24) et ladite borne d'entrée (IN20) ; **caractérisée en ce qu'**elle comprend :

- un premier bloc-commutateurs (SW1) connecté entre ladite borne d'entrée (IN20) et lesdits premier et deuxième coefficients d'intégration (32, 33) ;
- un deuxième bloc-commutateurs (SW2) connecté entre lesdits premier et deuxième intégrateurs (23, 24) ;
- un troisième bloc-commutateurs (SW3) connecté entre ledit deuxième intégrateur (24) et ladite borne de sortie (OUT20) ;
- un quatrième bloc-commutateurs (SW4) connecté à l'intérieur de ladite boucle d'oscillation (22) ; et
- un cinquième bloc-commutateurs (SW5) connecté entre ledit deuxième intégrateur (24) et ledit coefficient de réaction (35),

et **en ce qu'**elle comprend, en outre, une partie de correction d'erreur de phase (18) connectée, en réaction, entre une borne de sortie et une borne d'entrée dudit deuxième intégrateur (24), ladite partie de correction (18) ayant une valeur de capacité variable (Cv) qui est modifiée en fonction d'un compte (N1) d'échantillons de réponse à l'impulsion qui se trouvent au-dessus d'un ensemble de valeurs seuils (y1).

**11.** Structure de modulateur (20) avec une correction d'erreur de phase selon la revendication 10, **caractérisé en ce que** ledit quatrième bloc commutateur (SW4) permet que ladite boucle d'oscillation (22) soit brisée pour appliquer un signal d'impulsion (IMP2), et **en ce que** ledit troisième bloc commutateur (SW3) permet que la réponse à l'impulsion de ladite structure de modulateur (20) soit mesurée.

**12.** Structure de modulateur (20) avec une correction d'erreur de phase selon la revendication 10, **caractérisé en ce**

**que** lesdits premier, quatrième, cinquième et troisième bloc-commutateurs (SW1, SW4, SW5, SW3) sont remis à zéro de manière séquentielle pour permettre les opérations séquentielles suivantes :

1) lecture de la valeur d'un paramètre d'erreur de phase ($b_1$) dudit premier intégrateur (23) pour annuler la contribution de ladite borne d'entrée (IN20) en appliquant un signal d'impulsion (IMP1) au dit premier intégrateur (24), en brisant ladite boucle d'oscillation (22), et en connectant la sortie dudit premier intégrateur (23) à un convertisseur analogique - numérique Flash ;

2) calcul de la différence de ladite valeur lue dudit paramètre d'erreur de phase ($b_1$) avec une valeur seuil de celui-ci ;

3) étalonnage de ladite valeur lue dudit paramètre d'erreur de phase ($b_1$) en programmant ladite valeur de capacité variable (Cv) de ladite partie de correction d'erreur de phase (18), dans laquelle ledit premier intégrateur (23) est fourni, en utilisant les résultats obtenus grâce à l'étape de calcul 2 ci-dessus ; et

4) répétition de l'étape de lecture 1, de l'étape de calcul 2 et de l'étape d'étalonnage 3 jusqu'à ce que ladite valeur lue dudit paramètre d'erreur de phase ($b_1$) soit égale à ladite valeur cible.

**13.** Structure de modulateur (20) avec une correction d'erreur de phase selon la revendication 12, **caractérisée en ce que** lesdites opérations séquentielles sont également appliquées au dit deuxième intégrateur (24) en remettant à zéro initialement ledit deuxième bloc commutateur (SW2).

**14.** Structure de modulateur (20) avec une correction d'erreur de phase selon la revendication 10, **caractérisée en ce que** ledit deuxième bloc commutateur (SW2) comprend au moins un commutateur (TR2) qui reçoit au moins un signal d'impulsion (IMP1).

**15.** Structure de modulateur (20) avec une correction d'erreur de phase selon la revendication 10, **caractérisée en ce que** ledit troisième bloc-commutateur (SW3) comprend au moins un commutateur (TR3) qui reçoit des signaux de sortie envoyés par lesdits premier et deuxième intégrateur (23, 24).

**16.** Structure de modulateur (20) avec une correction d'erreur de phase selon la revendication 10, **caractérisée en ce que** ledit quatrième bloc commutateur (SW4) comprend au moins un commutateur (TR4) qui reçoit au moins un signal d'impulsion (IMP2).

**17.** Structure de modulateur (20) avec une correction d'erreur de phase selon la revendication 10, **caractérisée en ce que** ledit cinquième bloc commutateur (SW5) comprend au moins un commutateur (TR5) qui reçoit un signal de sortie envoyé par ledit deuxième intégrateur (24).

**18.** Structure de modulateur (20) avec une correction d'erreur de phase selon la revendication 10, **caractérisée en ce que** ladite partie de correction (18) comprend essentiellement un troisième condensateur (C3) connecté entre ladite borne de sortie et ladite borne d'entrée dudit deuxième intégrateur (24), ledit troisième condensateur (C3) ayant une valeur de capacité variable (Cv) et étant conçu pour produire une réaction positive autour dudit deuxième intégrateur (24).

**19.** Structure de modulateur (20) avec une correction d'erreur de phase selon la revendication 18, **caractérisée en ce que** ledit troisième condensateur (C3) est connecté entre ladite borne de sortie et ladite borne d'entrée dudit deuxième intégrateur (17) par l'intermédiaire de paires de commutateurs supplémentaires (SI31, SI32 ; SO31, SO32) entraînés par des premier et second signaux de phase ($\varphi1$, $\varphi2$).

**20.** Structure de modulateur (20) avec une correction d'erreur de phase selon la revendication 10, **caractérisée en ce qu'**elle comprend une partie de correction supplémentaire (19) connectée au dit deuxième intégrateur (24) symétriquement à ladite partie de correction (18).

FIG. 1
PRIOR ART

FIG. 2
PRIOR ART

EP 1 324 498 B1

FIG. 3
PRIOR ART

FIG. 4
PRIOR ART

EP 1 324 498 B1

FIG. 5

FIG. 6

FIG. 7

IN20

K1
K2
TR1
SW1
32
33
SW5
K6
K7
TR2
35
31
34
24
TR3
30
23
SW2
K3
IMP1
TR2
K4
SW3
25
26
ROUT20
27
OUT20
22
K5
IMP2
TR4
SW4
29
28

20

EP 1 324 498 B1

23